# EUROPEAN PATENT APPLICATION

(11) **EP 4 471 445 A1**
(43) Date of publication of application: **04.12.2024**
(21) Application number: 23176801.1
(22) Date of filing: 01.06.2023
(51) Int. Cl.: G01R 33/00, G01R 33/07

(54) **METHOD OF DETECTING OPENING OF A PACKAGE, AND A PACKAGE FOR USE IN A PARCEL AND POSTAL DISTRIBUTION SYSTEM**

(71) Applicant: SwipBox Development ApS, 6400 Sønderborg (DK)
(72) Inventor: Kaczmarek, Allan, 6400 Sønderborg (DK)
(74) Representative: Patrade A/S

(57) **Abstract**

Method (1000) of detecting opening of a package (10) for use in a parcel and postal distribution system, wherein the package (10) defines an internal space (12) for storage and the package (10) has a closeable opening (20), wherein the package (10) being in a closed state (22) at least by means of magnetic attraction forces established between the package (10) and the closeable opening (24) by permanent magnetic material interacting with other magnetic material at one or more nodes (30), wherein change of state is detected (1100) by measuring a change in magnetic field at or near the one or more nodes.

## Description

### Field of the Invention

The present invention relates to a method for detecting opening of a package used in a parcel and postal distribution system.

The present invention relates to a package capable of detecting if the package has been opened.

### Background of the Invention

Presently, cardboard boxes are almost exclusively used as packaging in parcel and postal distribution systems, due to the low costs and reliability. The cardboard boxes are usually closed using tape. It is very easy for a person acting in bad faith to break into packages of cardboard boxes, however it is also very easy to prove that there has been a break-in, due to the tape damaging the cardboard box, or due to cuts in the cardboard box. The opening of a cardboard box is typically non-reversible.

Cardboard boxes are thus not environmentally friendly due to one-time use before the cardboard is treated to mixed with virgin cardboard to form new cardboard boxes. This requires energy and hence results in the emittance of CO2.

This can be solved by using a package which can be reused multiple number of times. This will typically require that the package has a reliable and reversible closing mechanism for the package to be reused without any repairs. Consequently, the reusable package will not have any proof of a person having opened the package during transportation to the recipient. Thus, there is a need for a reusable package with a reversible closing mechanism, which package is capable of detecting if the package has been opened.

### Object of the Invention

It is an object of the invention to provide a method of detecting opening of a package and a package capable of detecting opening of said package.

### Description of the Invention

An object of the invention is achieved by a method of detecting opening of a package for use in a parcel and postal distribution system, wherein the package defines an internal space for storage and the package has a closeable opening, wherein the package being in a closed state at least by means of magnetic attraction forces established between the package and the closeable opening by permanent magnetic material interacting with other magnetic material at one or more nodes, wherein change of state is detected by measuring a change in magnetic field at or near the one or more nodes.

The internal space is for storage of the item or items to be sent to a recipient. The closeable opening can be permanently attached to the package such as pivotable attached, but the closeable opening may be completely removable from the package. However, the closeable opening is preferably permanently attached to the package as it reduces the risk of losing the closeable opening.

The closeable opening can form part of a top or a bottom of the package or sides between the top and bottom of the package. It is not required that closeable opening forms the entire side of the package, however the closeable opening should be large enough to enable a person to either collect from or place in the internal space.

The package has two states. The open state where the internal space is accessible and the closed state where the internal space is not accessible. The package is closed using at least permanent magnetic material interacting with other magnetic material at one or more nodes. Thus, change of state to an open state will cause the magnetic material and the other magnetic material to be removed by one another and consequently the magnetic field will change at or near the one or more nodes. The change is detected and thus the receiver can be informed that the package has been opened between the sender and the receiver or the courier can be informed that the package has been opened.

The state of the package is reversible as the closeable opening can be closed by letting the permanent magnetic material interact with other magnetic material. The change of state can in theory be repeated an infinite number of times.

Other components may be used for closing the package. Hook and loop fasteners may be used at the node and/or between the nodes. A hook and loop fastener is a reversible closing mechanism and can be used a plurality of times.

In the embodiment, where at least one of the one or more nodes includes a hook and loop fastener, the number of false change of states can be reduced drastically as the package becomes less sensitive to an external force or friction force from something frictionally engaging the node.

A zipper may be used at the node and/or between the nodes. The zipper is likewise a reversible closing mechanism and can be used a plurality of times.

One or more buttons may be used at the node and/or between the nodes. The one or more buttons are likewise a reversible closing mechanism and can be used a plurality of times.

At least one of the nodes may be positioned in the internal space, this is possible due to the magnetic attraction forces as the permanent magnetic material will attract the other magnetic material. This will make it significantly harder to tamper with the package.

In an embodiment, the detection may be performed by one or more Hall effect sensors, and/or one or more reed switches and/or one or more induction sensors. The method is preferably performed by Hall effect sensors as these sensors are reliable.

In an embodiment, the detection may be performed along two or more dimensions. This will reduce the number of false detections since the magnetic field is measured along two or more dimensions. The detection may be performed along two or more dimensions at the one or more nodes.

In an embodiment, the method may include displaying on a display that the opening of the package has been detected. Opening is detected when the state of package is changed from closed state to open state. The reversal from open state to closed state will not change the display as this will require a reset since the receiver or courier should receive the information that an opening of the package has been detected.

The method may include displaying using one or more LEDs or similar light sources that a change of state to the open state has been detected. This can be by turning on a red LED or a LED of another colour or a number of LEDs.

In an embodiment, the method may include a step of storing a time when the opening of the package is detected. Thereby, it will be possible to determine when and at what point of the transportation route the package was opened, the point could be at a distribution central or during transportation between distribution centrals or during the last mile or a pick-up drop-off service point or by the recipient.

The package may store the time at any change of state of the package such that the package history can be required.

In an embodiment, the package may comprise paperboard, cardboard, expanded polystyrene (EPS), polyethylene (PE), polypropylene (PP), polystyrene (PS), and polyvinyl chloride (PVC), plastics, wood, metal, or fabric or a combination.

An object of the invention is achieved by a package for use in a parcel and postal distribution system, the package defines an internal space for storage and the package comprises a closeable opening,
wherein the package has a closed state, where the internal space is not accessible through the closeable opening, and an open state, where the internal space is accessible through the closeable opening,
wherein the package being in the closed state at least by means of magnetic attraction forces established between the package and the closeable opening by permanent magnetic material interacting with other magnetic material at one or more nodes, wherein the package comprises a switch for detecting change of state, the switch being connected to one or more sensors at or near the one or more nodes and the switch detects a change of state as a function of sensor data.

The internal space is for storage of the item or items to be sent to a recipient. The closeable opening can be permanently attached to the package such as pivotable attached, but the closeable opening may be completely removable from the package. However, the closeable opening is preferably permanently attached to the package as it reduces the risk of losing the closeable opening.

The closeable opening can form part of a top or a bottom of the package or sides between the top and bottom of the package. It is not required that the closeable opening forms the entire side of the package, however the closeable opening should be large enough to enable a person to either collect from or place in the internal space.

The package has two states. The open state where the internal space is accessible and the closed state where the internal space is not accessible. The package is closed using at least permanent magnetic material interacting with other magnetic material at one or more nodes. Thus, change of state to an open state will cause the magnetic material and the other magnetic material to be removed by one another and consequently the magnetic field will change at or near the one or more nodes. The change is detected and thus the receiver can be informed that the package has been opened between the sender and the receiver or the courier can be informed that the package has been opened. The switch detects a change of state, which switch may be read to receive information about change of state.

The switch will during transportation until delivery store if there has been a change of state of the package such that a person in bad faith simply cannot close the package. In short, the switch detects the change of state from closed state to open state.

The state of the package is reversible as the closeable opening can be closed by letting the permanent magnetic material interact with other magnetic material. The change of state can in theory be repeated an infinite number of times.

At least one of the nodes may be positioned in the internal space, this is possible due to the magnetic attraction forces as the permanent magnetic material will attract the other magnetic material. This will make it significantly harder to tamper with the package.

The node and the sensor can be positioned outside the internal space, i.e. on the outside of the package and/or the node and the sensor can be positioned inside the internal space, i.e. inside the package. However, the node and the sensor can be placed on opposite sides of the package. A package may have a mixture of nodes positioned inside or outside the internal space.

The closeable opening may be a side of the package or part of the side of the package. The closeable opening may be rigid, semi-rigid or bendable.

In an embodiment, the package may be in the closed state by
- hook and loop fasteners; and/or
- buttons, such as a click button, and/or
- zippers and/or
- a toggle latch.

Other components may be used for closing the package. Hook and loop fasteners may be used at the node and/or between the nodes. A hook and loop fastener is a reversible closing mechanism and can be used a plurality of times.

In the embodiment, where at least one of the one or more nodes includes a hook and loop fastener, the number of false change of states can be reduced drastically as the package becomes less sensitive to an external force or friction force from something frictionally engaging the node.

A zipper may be used at the node and/or between the nodes. The zipper is likewise a reversible closing mechanism and can be used a plurality of times.

One or more buttons may be used at the node and/or between the nodes. The one or more buttons are likewise a reversible closing mechanism and can be used a plurality of times.

The toggle latch may be an over-center toggle latch.

In some embodiments, the node is formed at the toggle latch, wherein the latch body is equipped with permanent magnetic material or other magnetic material and the corresponding surface of the package may then be equipped with complementary permanent magnetic material or other magnetic material, thereby forming the node when the toggle latch is in a tensile position.

The striker for the toggle latch may be formed in either the closeable opening or the package. Likewise, the toggle latch may be attached to the closeable opening or the packages. A package may have mixture where one or more toggle latches are connected to the package with corresponding strikers on the closeable opening and where one or more toggle latches are connected to the closeable opening with corresponding strikers on the package.

In an embodiment, the package may comprise a smart tag including a smart tag controller, a smart tag energy storage, and optionally a display,
wherein the smart tag is connected to the one or more sensors and the smart tag controller comprises a processor, a computer-readable medium that includes program code,
wherein the memory and the program are configured to cause the processor to act as the switch; or
wherein the smart tag is connected to the one or more sensors through the switch to receive sensor data.

The smart tag can thus either act as the switch and be directly connected to one or more sensors or the smart tag is connected to a switch which is then connected to the one or more sensors.

In the embodiments with the display, the display may be used to present information such as data regarding the recipient or delivery address or other information. The display may include an e-ink display or e-paper display or similar bi-stable technology.

The smart tag may have additional functions such as additional sensors such as humidity sensors, accelerometers, and/or gyroscope or other sensors.

The smart tag may further include a communication module to communicate via wired or preferably wireless communication with third-party devices. Thereby, the smart tag can communicate if there has been a change of state from closed state to open state. Thereby, the smart tag does not need to have any visual indication that there has been a change of state; however the smart tag may have both a display and a communication module.

The communication module may include Bluetooth such as Bluetooth low-energy, NFC, Zigbee or wired communication such as USB.

In an embodiment, the memory and the program are further configured to cause the processor to include a warning on the display, that the state has been changed to the open state. Thereby, the receiver or courier will be able to see that the package has been opened at one point during transportation.

The smart tag may include one or more LEDs or similar light sources, which are activated when that a change of state to the open state has been detected. This can be by turning on a red LED or a LED of another colour or a number of LEDs.

In an embodiment, the smart tag controller includes a clock unit and the memory and the program is further configured to cause the processor to store the time when there is a change of state. Thereby, it will be possible to determine when and at what point of the transportation route the package was opened, the point could be at a distribution central or during transportation between distribution centrals or during the last mile or a pick-up drop-off service point or by the recipient.

The package may store the time at any change of state of the package such that the package history can be required.

In an embodiment, the one or more sensors being one or more Hall effect sensors, and/or one or more reed switches and/or one or more induction sensors. The Hall effect sensors are preferred, as these sensors are reliable.

In an embodiment, the package may comprise paperboard, cardboard, expanded polystyrene (EPS), polyethylene (PE), polypropylene (PP), polystyrene (PS), and polyvinyl chloride (PVC), plastics, wood, metal, or fabric or a combination.

An object of the invention is achieved by a computer program product comprising instructions which, when the program is executed by a package according to the invention, cause the computer to carry out the method according to the invention.

An object of the invention is achieved by a computer-readable medium having stored thereon the computer program product.

### Description of the Drawings

Embodiments of the invention will be described in the figures, whereon:
- Fig. 1: illustrates a first embodiment of the package with a switch;
- Fig. 2: illustrates a second embodiment of the package with a smart tag;
- Fig. 3: illustrates a third embodiment of the package;
- Fig. 4: illustrates states of the closeable opening;
- Fig. 5: illustrates a smart tag;
- Fig. 6: illustrates a method of detecting opening of a package (10) for use in a parcel and postal distribution system;
- Fig. 7: illustrates fourth embodiment of the package with a zipper; and
- Fig. 8: illustrates a toggle latch.

### Detailed Description of the Invention

| **Item** | **No** |
|---|---|
| Package | 10 |
| Internal space | 12 |
| Closeable opening | 20 |
| Closed state | 22 |
| Open state | 24 |
| Flaps | 26 |
| Node | 30, 301, 3011, 30III, 30IV |
| Display | 40 |
| Switch | 50 |
| Sensor | 60, 60I, 60II, 60III, 60IV |
| Smart tag | 70 |
| Smart tag controller | 72 |
| Smart tag energy storage | 74 |
| Processor | 76 |
| Computer-readable medium | 78 |
| Clock unit | 79 |
| Communication module | 80 |
| Method | 1000 |
| Detection | 1100 |
| Displaying | 1200 |
| Storing | 1300 |

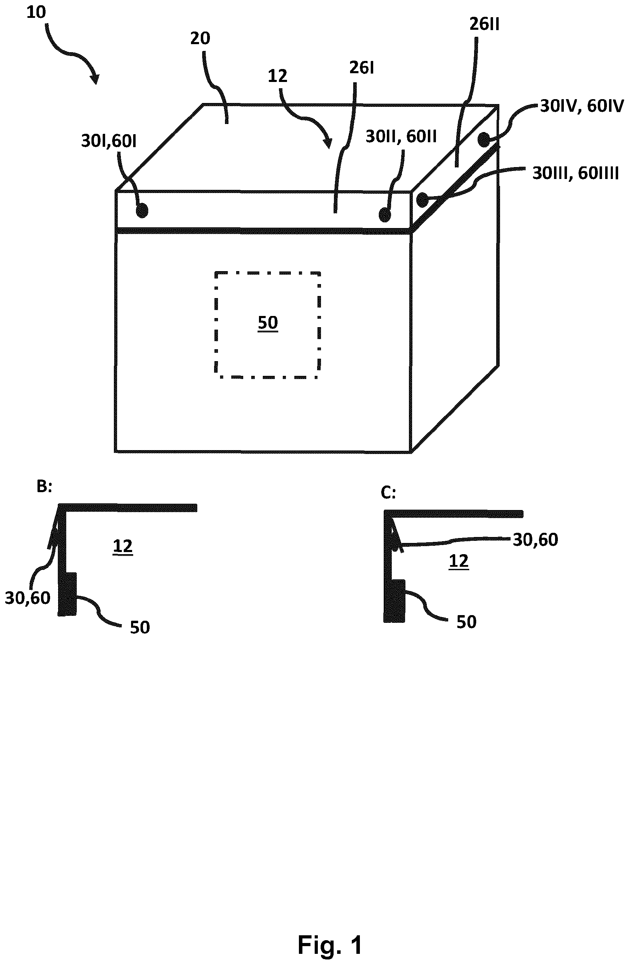

Fig. 1 illustrates a first embodiment of the package 10 with a switch 50. The package 10 defines an internal space 12 for storage of one or more items.

The package 10 has a closeable opening 20 for enabling access to the internal space 12. The closeable opening 20 is shown to be the entire top of the package 10, but the closeable opening 20 could be any one of the sides of the package 10 without changing the functionality. The closeable opening 20 has in this embodiment flaps extending down the sides of the package 20. Two flaps are disclosed but the closeable opening 20 could have three or more flaps.

The package 10 has a closed state 22, where the internal space 12 is not accessible through the closeable opening 20. The shown package 10 is in the closed state 22. The package 10 has an open state 24, where the internal space 12 is accessible through the closeable opening 20. The closeable opening 20 may be pivotally attached to the package 10 or be detachable from the package 10.

The package 10 is in the closed state 22 at least by means of magnetic attraction forces established between the package 10 and the closeable opening 20 by permanent magnetic material interacting with other magnetic materials at the nodes 30I, 30II, 30III, 30IV. The figure discloses four nodes 30I, 30II, 30III, 30IV but there may be more. The package 10 comprises a switch 50 for detecting change of state from the closed state 22 to the open state 24. The switch 50 being connected to one or more sensors 60I, 60II, 60III, 60IV at or near the one or more nodes 30I, 30II, 30III, 30IV and the switch 50 detects a change of state as a function of sensor data, where the sensors measure changes to magnetic field.

The switch 50 is in communication with the one or more sensors 60I, 60II, 60III, 60IV even though the communication is not shown in figure 1.

Figure 1B discloses that the node 30 and the sensor 60 can be positioned external to the internal space 12, i.e. on the outside of the package 10. The node 30 and the sensor 60 can be placed on opposite sides.

Figure 1C discloses that the node 30 and the sensor 60 can be positioned inside the internal space 12, i.e. on the outside of the package 10. The node 30 and the sensor 60 can be placed on opposite sides.

The package 10 and the flaps 26I, 26II may be further equipped with hook and loop fasteners; and/or one or more buttons, such as click buttons, and/or a zipper. The mating surfaces of the package 10 and the flaps 26I, 26II are complementary, for example one has hooks and the other surface has loops.

If the package 10 had a zipper, then it would not be required to have an overlapping surface between the sides of the package and the closeable opening.

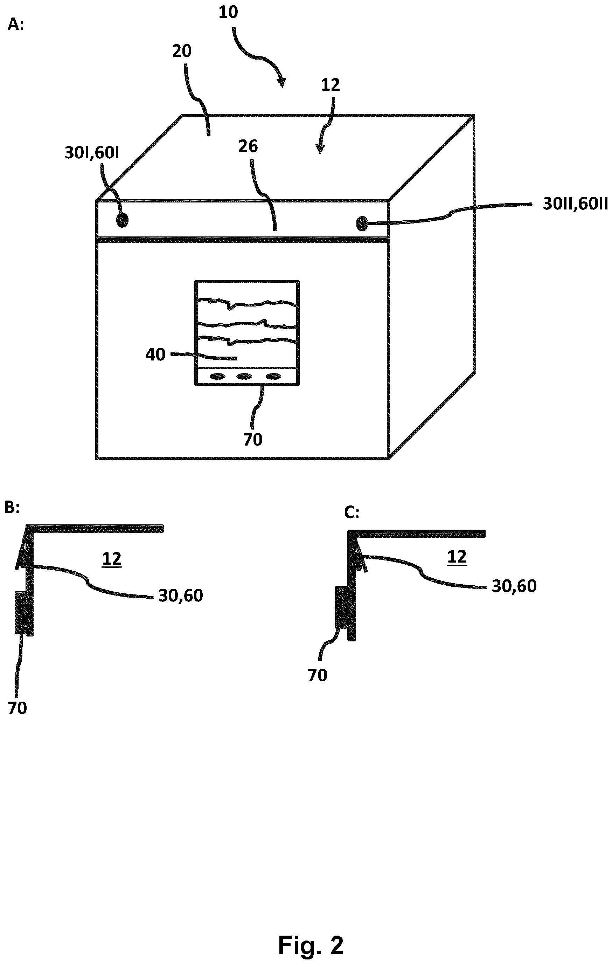

Fig. 2 illustrates a second embodiment of the package 10 with a smart tag 70. The package 10 defines an internal space 12 for storage of one or more items.

The package 10 has a closeable opening 20 for enabling access to the internal space 12. The closeable opening 20 is shown to be the entire top of the package 10, but the closeable opening 20 could be any one of the sides of the package 10 without changing the functionality. The closeable opening 20 has in this embodiment a flap extending down sides of the package 20. One flap is disclosed but the closeable opening 20 could have two or more flaps.

The package 10 has a closed state 22, where the internal space 12 is not accessible through the closeable opening 20. The shown package 10 is in the closed state 22. The package 10 has an open state 24, where the internal space 12 is accessible through the closeable opening 20. The closeable opening 20 may be pivotally attached to the package 10 or be detachable from the package 10.

The package 10 is in the closed state 22 at least by means of magnetic attraction forces established between the package 10 and the closeable opening 20 by permanent magnetic material interacting with other magnetic materials at the nodes 30I, 30II. The figure discloses two nodes 30I, 30II, but there may be more. The package 10 comprises a smart tag for detecting change of state from the closed state 22 to the open state 24. The smart tag 70 may be configured to act as a switch 50 or be in communication with a switch 50 (not shown). The smart tag 70 and/or switch 50 (not shown) is connected to sensors 60I, 60II, at or near the one or more nodes 30I, 30II, and the smart tag 70 and/or the switch 50 detects a change of state as a function of sensor data, where the sensors measure changes to magnetic field.

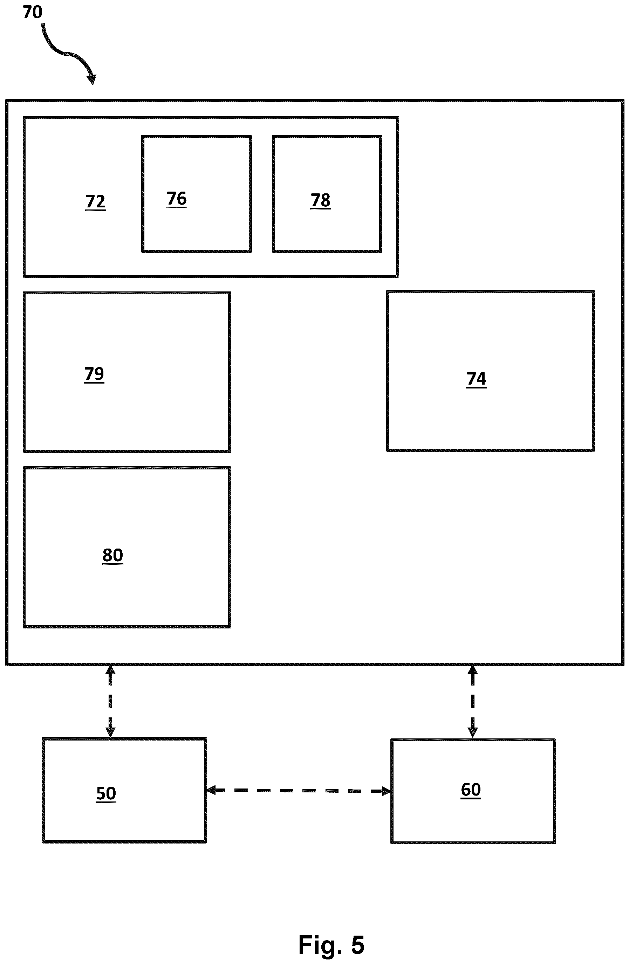

The smart tag 70 is in communication with the one or more sensors 60I, 6011, 60III, 60IV even though the communication is not shown in figure 2. The smart tag 70 is described in greater detail in figure 5. The smart tag 70 in figure 2 may be identical or similar to the smart tag 70 shown and discussed in figure 5.

Figure 2B discloses that the node 30 and the sensor 60 can be positioned external to the internal space 12, i.e. on the outside of the package 10. The node 30 and the sensor 60 can be placed on opposite sides.

Figure 2C discloses that the node 30 and the sensor 60 can be positioned inside the internal space 12, i.e. on the outside of the package 10. The node 30 and the sensor 60 can be placed on opposite sides.

The package 10 and the flaps 26I, 26II may be further equipped with hook and loop fasteners; and/or one or more buttons, such as click buttons, and/or a zipper. The mating surfaces of the package 10 and the flaps 26I, 26II are complementary for example one has hooks and the other surface has loops. If the package 10 had a zipper, then it would not be required to have an overlapping surface between the sides of the package and the closeable opening 20.

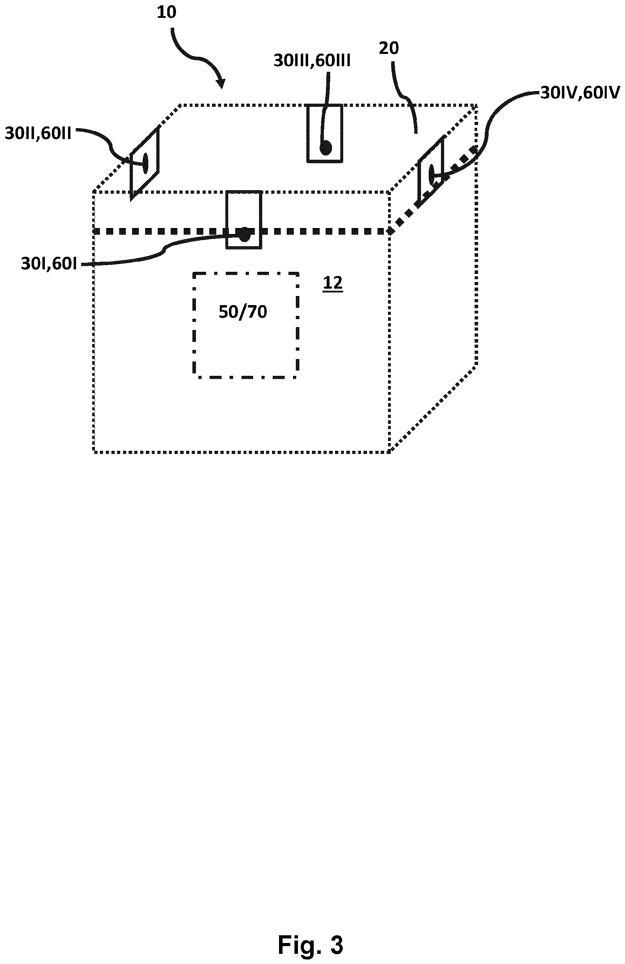

Fig. 3 illustrates a third embodiment of the package 20. The package 20 is dashed to represent that the four nodes 30I, 30II, 30III, 30IV are positioned inside the package, i.e. on the internal side 12 of the package 10. In this embodiment each side of the package 10 is equipped with one of the four nodes 30I, 30II, 30III, 30IV. At each node magnetic attraction forces are established between the package 10 and the closeable opening 24 by permanent magnetic material interacting with other magnetic material. The closeable opening 24 may be equipped with permanent magnetic material and/or the package 10 may be equipped with permanent magnetic material.

The nodes 30I, 30II, 30III, 30IV can be placed inside because the magnetic attraction will ensure that each part of the node will find the other part of the node such that the parts mate into the respective nodes 30I, 30II, 30III, 30IV.

The package 10 may be equipped with a switch 50 and/or smart tag as previously described for figures 1 and 2 as the functioning is the same or at least similar.

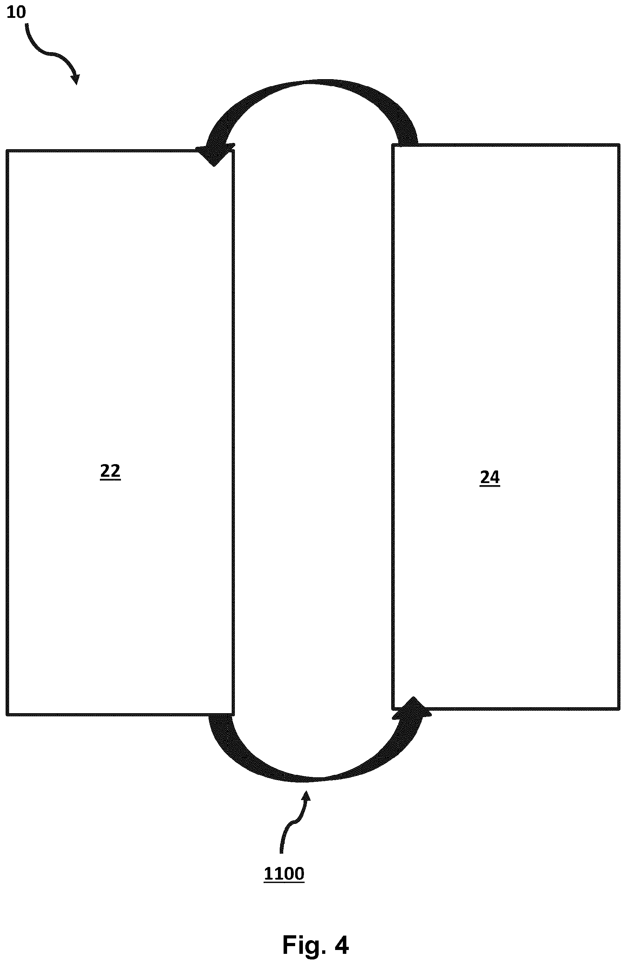

Fig. 4 illustrates states 22,24 of the package 10. The package 10 has two states 22,24, wherein the package 10 is in the closed state 22, when the internal space 12 is not accessible through the closeable opening 20, and the package 10 is in the open state 24, where the internal space 12 is accessible through the closeable opening 20. The step of detection 1100 is focused on detecting the change from closed state 22 to the open state 24, because that means the package 10 has been opened at some point during transportation. The change from the open state 24 to the closed state 22 may also be detected but it is not relevant to the recipient of the package 10. The package 10 must not be opened during transportation and thus any later change of state is typically irrelevant. This may be communicated to the recipient in any way possible i.e., via a display, LEDs and/or electronic messages or by other suitable means.

The purpose of the package 10 is to be reused thus the owner or the sender of the parcel may be able to reset the package 10 such that the package 10 is able to detect a new change of state form the closed state 22 to the open state 24. This may be performed by sending a specific instruction to the switch 50 or smart tag 70.

Fig. 5 illustrates a smart tag 70. The smart tag 70 includes a smart tag controller 72, a smart tag energy storage 74, and optionally a display 40 for displaying relevant information and/or a communication module 80. The energy storage 74 is for powering the smart tag 70, the smart tag 70 may be a battery unit.

The smart tag 70 is connected to the one or more sensors 60 and the smart tag controller 72 comprises a processor 76, a computer-readable medium 78 that includes program code. The memory 78 and the program are configured to cause the processor 76 to act as the switch 50; or the smart tag 70 is connected to the one or more sensors 60 through the switch 50 to receive information. Thus, the smart tag 70 can detect change of state as a function of the received sensor data.

The smart tag 70 may include a clock unit 79, such that the time of the change of state from the closed state 22 to the open state 24 can be stored which time can be used to find where the unauthorized change of state was performed.

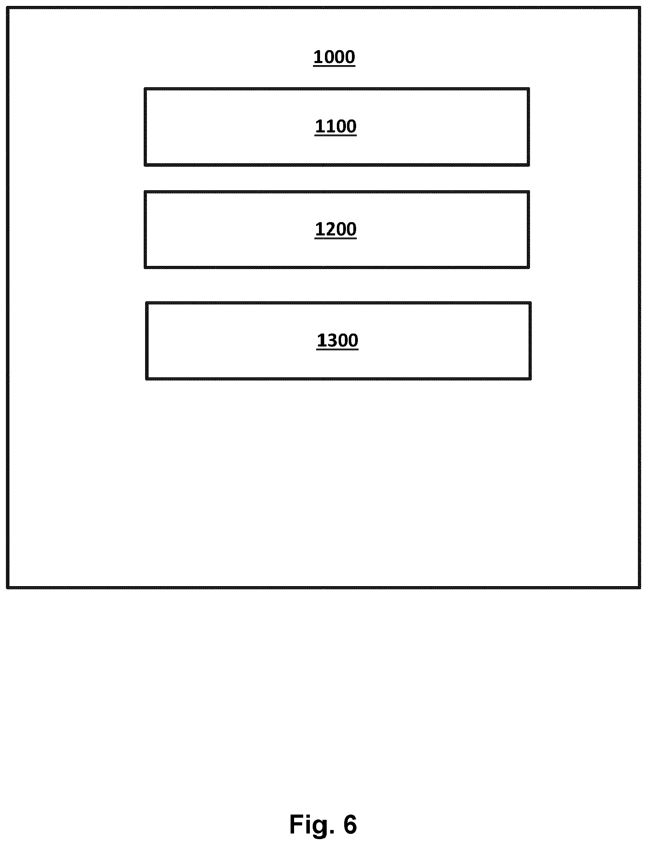

Fig. 6 illustrates a method 1000 of detecting opening of a package 10 for use in a parcel and postal distribution system. The change of state is detected 1100 by measuring a change in magnetic field at or near the one or more nodes using one or more sensors.

The detection 1100 may be performed by one or more Hall effect sensors, and/or one or more reed switches and/or one or more induction sensors. The detection 1100 may be performed along two or more dimensions.

The method 1000 may include displaying 1200 on a display 40 that the opening of the package 10 has been detected.

The method may include a step of storing 1300 a time when the opening of the package 10 is detected. This enables determination with some degree of certainty of where the package 10 was opened. The opening may be registered at a time where the package 10 was positioned on a distribution central.

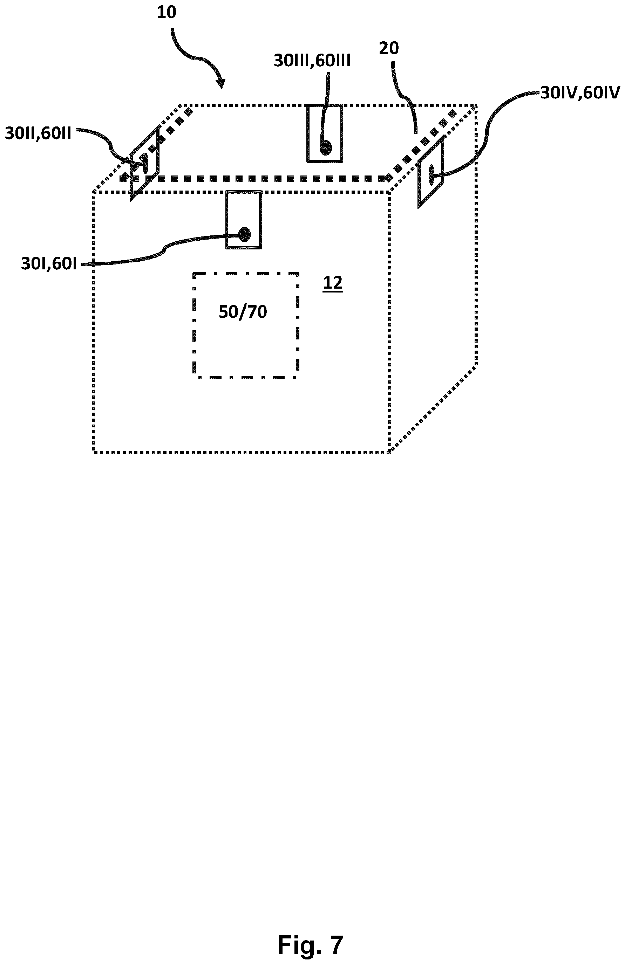

Fig. 7 illustrates fourth embodiment of the package with a zipper. The shown embodiment is identical to the embodiment in figure 4 with the exception of the package 10 having a zipper instead of flaps.

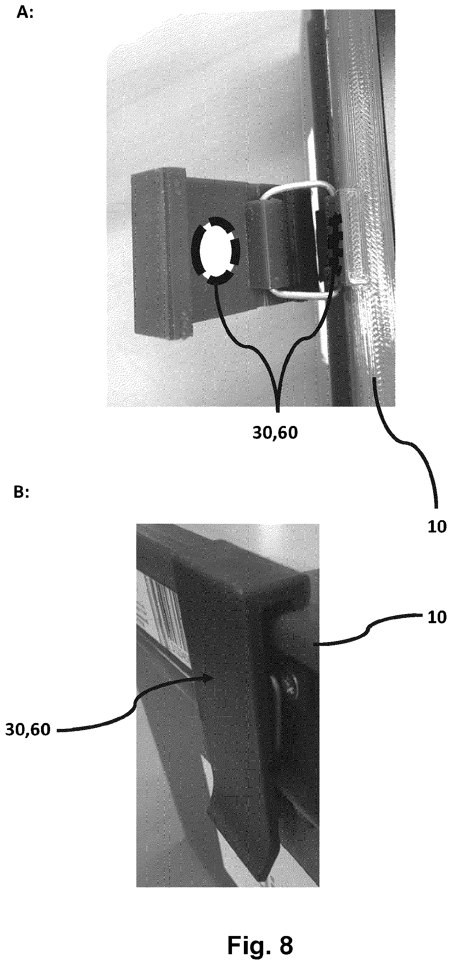

Fig. 8 illustrates a toggle latch on a package 10. The toggle latch forms the node 30 and thus a sensor is placed at the node 30.

## Claims

1. Method (1000) of detecting opening of a package (10) for use in a parcel and postal distribution system, wherein the package (10) defines an internal space (12) for storage and the package (10) has a closeable opening (20), wherein the package (10) being in a closed state (22) at least by means of magnetic attraction forces established between the package (10) and the closeable opening (24) by permanent magnetic material interacting with other magnetic material at one or more nodes (30), wherein change of state is detected (1100) by measuring a change in magnetic field at or near the one or more nodes.

2. Method (1000) according to claim 1, wherein detection (1100) is performed by one or more Hall effect sensors, and/or one or more reed switches and/or one or more induction sensors.

3. Method (1000) according to claim 1 or 2, wherein detection (1100) is performed along two or more dimensions.

4. Method (1000) according to any of claims 1 to 3, wherein the method (1000) includes - displaying (1200) on a display (40) that the opening of the package (10) has been detected.

5. Method (1000) according to any of claims 1 to 4, wherein the method includes a step of storing (1300) a time when the opening of the package (10) is detected.

6. Method (1000) according to any of claims 1 to 5, wherein the package (10) comprises paperboard, cardboard, expanded polystyrene (EPS), polyethylene (PE), polypropylene (PP), polystyrene (PS), and polyvinyl chloride (PVC), plastics, wood, a metal, or fabric or a combination.

7. A package (10) for use in a parcel and postal distribution system, the package (10) defines an internal space (12) for storage and the package comprises a closeable opening (20), wherein the package (10) has a closed state (22), where the internal space (12) is not accessible through the closeable opening (20), and an open state (24), where the internal space (12) is accessible through the closeable opening (20),
wherein the package (10) being in the closed state (22) at least by means of magnetic attraction forces established between the package (10) and the closeable opening (20) by permanent magnetic material interacting with other magnetic material at one or more nodes (30), wherein the package (10) comprises a switch (50) for detecting change of state, the switch (50) being connected to one or more sensors (60) at or near the one or more nodes (30) and the switch (50) detects a change of state as a function of sensor data.

8. A package (10) according to claim 7, wherein the package (10) being in the closed state () by
- hook and loop fasteners; and/or
- one or more buttons, such as a click button, and/or
- a zipper and/or
- a toggle latch.

9. A package (10) according to claim 7 or 8, wherein the package (10) comprises a smart tag (70) including a smart tag controller (72), a smart tag energy storage (74), and optionally a display (40),
wherein the smart tag (70) is connected to the one or more sensors (60) and the smart tag controller (72) comprises a processor (76), a computer-readable medium (78) that includes program code,
wherein the memory (78) and the program are configured to cause the processor (76) to act as the switch (50); or
wherein the smart tag (70) is connected to the one or more sensors (70) through the switch (50) to receive sensor data.

10. A package (10) according to claim 9, wherein the memory and the program are further configured to cause the processor (76) to include a warning on the display (40), that the state has been changed to the open state (24).

11. A package (10) according to claim 9 or 10, wherein the smart tag controller (72) includes a clock unit (9) and the memory and the program is further configured to cause the processor (76) to store the time when there is a change of state.

12. A package (10) according to any one of claims 7 to 11, wherein the one or more sensors (60) being one or more Hall effect sensors, and/or one or more reed switches and/or one or more induction sensors.

13. A package (10) according to any one of claims 7 to 12, wherein the package (10) comprising paperboard, cardboard, expanded polystyrene (EPS), polyethylene (PE), polypropylene (PP), polystyrene (PS), and polyvinyl chloride (PVC), plastics, wood, metal, or fabric or a combination.

14. A computer program product comprising instructions which, when the program is executed by a package (10) according to any of claims 7 to 13, cause the computer to carry out the method of any of claims 1 to 6.

15. A computer-readable medium (78) having stored thereon the computer program product of claim 14.
